# EUROPEAN PATENT APPLICATION

(11) **EP 4 812 005 A1**
(43) Date of publication of application: **23.09.2026**
(21) Application number: 26165092.3
(22) Date of filing: 16.03.2026
(51) Int. Cl.: H10W 40/73, H10W 40/47, H10W 40/22, H10W 40/00

(54) **FIN FOR NUCLEATE AND FLOW BOILING ENHANCEMENTS**

(30) Priority: 17.03.2025 US 202563773023 P
(71) Applicant: Carrier Corporation, Palm Beach Gardens, FL 33418 (US)
(72) Inventor: MOHANTA, Lokanath, East Syracuse, 13057 (US); JOARDAR, Arindom, East Syracuse, 13057 (US)
(74) Representative: Dehns

(57) **Abstract**

A heat removal device (100) operable to cool a heat-generating device (62) includes a housing (200) having a hollow interior (202) and a base (102) arranged within the hollow interior (202) of the housing (200). The base (102) includes a contact surface (104) and a cooling surface (106). The contact surface (104) is thermally couplable to the heat-generating device (62). At least one fin (120) including a plurality of fin segments (140) is arranged at the cooling surface (106). At least one of the plurality of fin segments (140) includes a plurality of louvers (150).

## Description

### BACKGROUND

Exemplary embodiments pertain to the art of cooling devices, and more particularly to cooling device used to cool power electronics.

Power electronics devices such as motor drives and computing devices such as CPU's or GPU's generate waste heat during operation of the device. Additionally, when the electronics devices heat up, the operational efficiency of the devices can degrade adding to the amount of heat generated. When utilized in a refrigeration system to drive, for example, a compressor of the refrigeration system, effective thermal integration of these devices can be important aspect to the system's overall efficiency and reliability. Consequently, a goal of the system integrator is to maintain these components within a range of operating temperatures which will maximize the system efficiency. Accordingly, there remains a need in the art for a cooling device or heat sink that can closely integrate with electronic devices which can maintain optimal temperatures for these components under a variety of load conditions.

Heat transfer performance of a heat sink can be improved via one or more of the following methods: (i) increasing the heat transfer surface area of the heat sink, (ii) promoting two phase flow such nucleate boiling on the surface of the heat sink that is in contact with the boiling fluid, (iii) promoting external natural convection at the enhanced surface of the heatsink, and (iv) promoting convection boiling or thin film boiling in the heat sink.

In the nucleate or thin film boiling process, initially, a small quantity of entrapped vapor, in the form of a bubble, in the nucleation sites or cavities grows due to the heat transferred from the heated surface. When the bubble grows, it vaporizes more liquid in contact with the solid surface and also vaporizes at the liquid-vapor interface. Heat from the solid surface and from the surrounding superheated liquid superheats the vapor in a bubble causing the bubble to grow in size. When the bubble is large enough, the surface tension of the bubble is overcome by the buoyancy force causing the bubble to detach from the surface. As the bubble leaves the surface, liquid enters the volume vacated by the bubble. This movement of the bubble results in a convection current in the liquid. Some tracesof vapor may remain in the cavity volume and become a source of additional liquid to vaporize to form another bubble. The periodic formation of bubbles at the surface, the release of the bubbles from the surface, and the rewetting of the surface together with the convective effect of the vapor bubbles rising through the liquid results in an improved heat transfer rate for the heat transfer surface.

However, in some configurations reaching film boiling will dry out quickly resulting in poor heat transfer. There is therefore a need for newly configured heat transfer surface design with improved heat transfer capabilities.

### BRIEF DESCRIPTION

According to a first aspect of the invention, there is provided a heat removal device operable to cool a heat-generating device, the heat removal device includes a housing having a hollow interior and a base arranged within the hollow interior of the housing. The base includes a contact surface and a cooling surface. The contact surface is thermally couplable to the heat-generating device. At least one fin including a plurality of fin segments is arranged at the cooling surface. At least one of the plurality of fin segments includes a plurality of louvers.

Optionally, the plurality of fin segments have a uniform axial fin height.

Optionally, the at least one fin includes a plurality of fins and each of the plurality of fins has a plurality of fin segments. The plurality of fin segments of each fin of the plurality of fins may have a uniform axial fin height.

Optionally, an axial fin height of the plurality of fin segments varies between an inlet of the housing toward an outlet of the housing.

Optionally, the at least one fin includes a single fin and the axial fin height of the plurality of fin segments of the single fin vary.

Optionally, the at least one fin includes a plurality of fins and each of the plurality of fins has a plurality of fin segments. The plurality of fin segments of each fin of the plurality of fins may have a uniform axial fin height.

Optionally, the plurality of fins includes a first fin and a second fin and the axial fin height of the plurality of fin segments of the first fin is different than the axial fin height of the plurality of fin segments of the second fin.

Optionally, the axial fin height of the plurality of fin segments varies in a first direction and a second direction. The second direction may be arranged at a non-parallel angle relative to the first direction.

Optionally, the at least one fin includes a plurality of fins mounted in a lateral direction of the base. The plurality of fins may be staggered relative to one another with respect to a longitudinal axis of the base.

Optionally, the at least one fin has one of a triangular waveform and a sinusoidal waveform.

Optionally, the at least one fin includes one of a hydrophilic material and a hydrophilic surface coating.

Optionally, the plurality of fin segments include louvers.

Optionally, a plurality of channels are formed between adjacent fin segments of the plurality of fin segments. The plurality of channels are fluidly connected by the louvers.

Optionally, a plurality of apex fin tips are defined at an interface between respective pairs of adjacent fin segments of the plurality of fin segments. At least one opening is formed at the plurality of apex fin tips.

Optionally, at least one baffle is positioned upwardly adjacent to the plurality of fin segments. The at least one baffle may have a plurality of perforations formed therein.

Optionally, the at least one baffle includes a plurality of baffles, and each of the plurality of baffles has a surface positioned closest to the fin. The surfaces positioned closest to the fins of each of the plurality of baffles may be arranged within different planes.

Optionally, the plurality of fin segments are arranged in groups of fin segments having different axial fin heights. Each baffle of the plurality of baffles may be associated with one of the groups of fin segments.

Optionally, the at least one baffle is separated from an adjacent surface of the housing by a clearance to define a vapor region within the hollow interior of the housing.

According to a second aspect of the invention a heat removal device operable to cool a heat-generating device is provided, the heat removal device includes a housing having a hollow interior and a base arranged within the hollow interior of the housing. The base includes a contact surface and a cooling surface. The contact surface is thermally couplable to the heat-generating device. At least one fin including a plurality of fin segments is arranged at the cooling surface. A plurality of apex fin tips are defined at an interface between respective pairs of adjacent fin segments of the plurality of fin segments. At least one opening is formed at the plurality of apex fin tips.

Optionally, a plurality of channels defined between adjacent fin segments.

Optionally, one or more of the plurality of channels is fluidly connected to an outlet of the housing via the at least one opening formed at the plurality of apex fin tips.

Optionally, at least one of the plurality of fin segments includes a plurality of louvers, and the plurality of channels are fluidly connected via the plurality of louvers.

### BRIEF DESCRIPTION OF THE DRAWINGS

Certain exemplary embodiments will now be described in greater detail by way of example only and with reference to the accompanying drawings, like elements being numbered alike, in which:
FIG. 1 is a schematic diagram of an example of a refrigeration system;
FIG. 2 is a schematic diagram of another example of a heating, ventilation, air conditioning and refrigeration (HVAC&R) system;
FIG. 3 is an illustration of a cooling system for cooling a heat-generating device;
FIG. 4 is a schematic diagram of a heat removal device of a cooling system;
FIG. 5A is a plan view of a heat removal device of a cooling system;
FIG. 5B is a perspective view of a plurality of fins of the heat removal device of FIG. 5A;
FIG. 6A is a plan view of a heat removal device of a cooling system;
FIG. 6B is a perspective view of a plurality of fins of the heat removal device of FIG. 6A;
FIG. 6C is a perspective view of a plurality of fins of the heat removal device of FIG. 6A;
FIG. 7 is a detailed perspective view of a fin of the heat removal device;
FIG. 8 is a perspective view of a fin including a plurality of louvers;
FIG. 9A is a perspective view of a fin configured for nucleate boiling;
FIG. 9B is a cross-sectional view of the fin of FIG. 9A;
FIG. 10A is a cross-sectional view of another fin configured for nucleate boiling;
FIG. 10B is a cross-sectional view of yet another fin configured for nucleate boiling;
FIG. 11 is a schematic diagram of a heat removal device of a cooling system;
FIG. 12 is a cross-sectional view of a fin configured for flow boiling;
FIG. 13A is a cross-sectional view of a fin configured for flow boiling;
FIG. 13B is a cross-sectional view of a yet another fin configured for flow boiling;
FIG. 14 is a schematic diagram of a heat removal device of a cooling system including a baffle;
FIG. 15A is a schematic diagram of a heat removal device of a cooling system including a fin having a varying axial fin height; and
FIG. 15B is a schematic diagram of a heat removal device of a cooling system including fins having a varying axial fin height.

### DETAILED DESCRIPTION

A detailed description of one or more embodiments of the disclosed apparatus and method are presented herein by way of exemplification and not limitation with reference to the Figures.

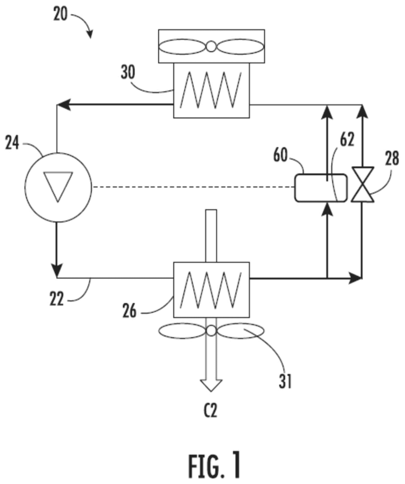

Referring to FIG. 1, an example of a refrigeration system, such as a heating, ventilation, air conditioning and refrigeration (HVAC) system 20 is schematically illustrated. Exemplary refrigeration systems 20 include, but are not limited to, residential, split, packaged, chiller, rooftop, supermarket, transport, and fuel cell systems, for example. In the illustrated, non-limiting embodiment, the refrigeration system 20 includes a refrigeration circuit 22 including a compressor 24, a condenser 26, an expansion device 28, such as an expansion valve, and an evaporator 30 arranged in series and having a volume of refrigeration fluid, such as refrigerant for example, flowing therethrough.

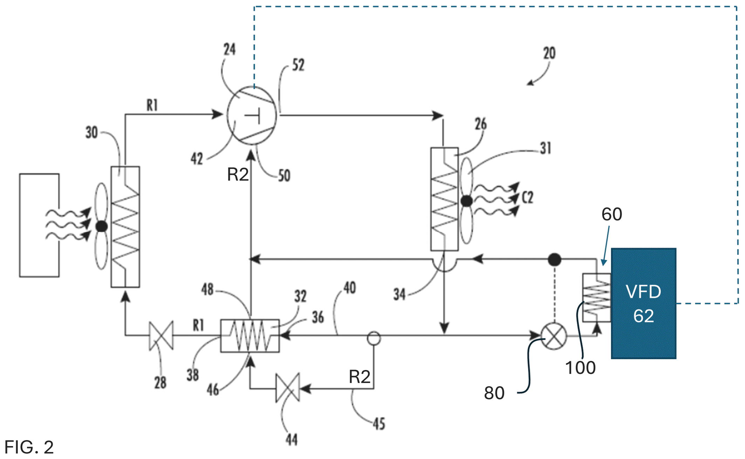

Another example of a refrigeration system 20 is illustrated in FIG. 2. In addition to the compressor 24, condenser 26, expansion device 28, and evaporator 30 previously described the refrigeration circuit 22 includes an economizer heat exchanger 32. The economizer heat exchanger 32 may be positioned between the condenser 26 and the expansion device 28 relative to a flow of refrigeration fluid through the refrigeration circuit 22. Although the economizer heat exchanger 32 is illustrated as being located directly downstream from the outlet 34 of the condenser 26, it should be understood that embodiments where one or more other components of the refrigeration system 20 are located between the condenser 26 and an inlet of the economizer heat exchanger 32 are also contemplated herein.

In an embodiment, the economizer heat exchanger 32 is a brazed plated fin heat exchanger. However, other suitable types of heat exchangers are also within the scope of the disclosure. Further, the economizer heat exchanger 32 is a refrigeration fluid-refrigeration fluid heat exchanger and therefore has a plurality of distinct fluid flow paths formed therein. In the illustrated, non-limiting embodiment, the economizer heat exchanger 32 has a first flow path and a second flow path, respectively.

In the illustrated, non-limiting embodiment, the inlet 36 of the first flow path of the economizer heat exchanger 32, also referred to herein as the "main flow path," is arranged in direct fluid communication with an outlet 34 of the condenser 26. Alternatively, or in addition, the outlet 38 of the main flow path of the economizer heat exchanger 32 may be arranged directly upstream from and in fluid communication with an inlet of the expansion device 28.

In operation, a first portion R1 of the refrigeration fluid output from the condenser 26 is provided to the main flow path of the economizer heat exchanger 32 via a main conduit 40. Although the main flow path is illustrated as a single pass through the economizer heat exchanger 32, it should be understood that in other embodiments the main flow path may include a plurality of passes through the economizer heat exchanger 32. At the outlet 38 of the main flow path of the economizer heat exchanger 32, the first portion R1 of the refrigeration fluid is configured to flow to the expansion device 28. From the expansion device 28, the refrigeration fluid is expanded within the evaporator 30. The first portion R1 of refrigeration fluid output from the evaporator 30 is provided via a first compressor inlet path to a primary suction inlet 42 of the compressor 24. Accordingly, the fluid loop of the first portion R1 of the refrigeration fluid includes the compressor 24, condenser 26, main flow path of the economizer heat exchanger 32, expansion device 28, and the evaporator 30.

An economizer expansion device 44 may be arranged within the refrigeration circuit 22 in fluid communication with the condenser 26. The economizer expansion device 44 is operable to expand and cool the refrigeration fluid provided thereto. Although the economizer expansion device 44 is illustrated as being disposed within an economizer conduit 45 fluidly coupled to an extending from the main conduit 40 at a location upstream from the first inlet 36, it should be understood that an economizer conduit 45 fluidly connected to the outlet 34 of the condenser 26 in another suitable manner is also contemplated herein.

Located downstream from the economizer expansion device 44 is the inlet 46 of a second flow path of the economizer heat exchanger 32, also referred to herein as the "economizer flow path." Further, the outlet 48 of the second flow path of the economizer heat exchanger 32 may but need not be directly connected to an economizer suction inlet or port 50 of the compressor 24. In the illustrated, non-limiting embodiment, the inlet 36 of the main flow path and the inlet 46 of the economizer flow path are arranged at adjacent sides of the economizer heat exchanger 32. However, in other embodiments, it should be understood that the inlets 36, 46 of both flow paths could alternatively be arranged at the same side of the economizer heat exchanger 32 or at opposite sides thereof. Similarly, the outlets 38, 48 of both the main flow path and the economizer flow path may be arranged at opposite sides, the same side, or adjacent sides depending on the desired flow configuration of the economizer heat exchanger 32. Further, although the economizer flow path is illustrated as a single pass, it should be understood that in some embodiments, the economizer flow path may include a plurality of passes through the economizer heat exchanger 32.

Within the economizer flow path, a second portion R2 of the refrigeration fluid is configured to absorb heat from the first portion R1 of the refrigeration fluid within the main flow path, thereby cooling the first portion R1 of the refrigeration fluid. As a result of this heat transfer, the second portion R2 of the refrigeration fluid within the economizer flow path may become a vapor. From the outlet 48 of the economizer flow path, the second portion R2 of the refrigeration fluid is provided to the economizer suction inlet 50 located at an intermediate portion of the compressor 24. Accordingly, the second portion R2 of the refrigeration fluid bypasses the expansion device 28 and the evaporator 30 of the refrigeration circuit 22. Within the compressor 24 the first portion R1 and the second portion R2 of refrigeration fluid are mixed before being provided to the discharge port 52 to repeat the cycle. Accordingly, the fluid loop of the second portion R2 of the refrigeration fluid includes the compressor 24, condenser 26, economizer expansion device 44, and economizer flow path of the economizer heat exchanger 32. It should be understood that the refrigeration systems 20 illustrated and described herein are intended as an example only, and that a refrigeration system 20 having another configuration is within the scope of the disclosure.

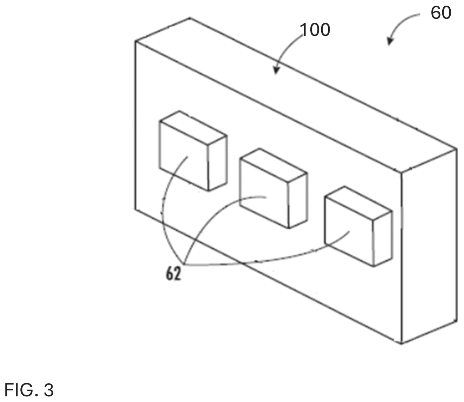

With continued reference to both FIGS. 1 and 2 and further reference to FIG. 3, in an embodiment, the refrigeration system 20 includes a cooling system 60 including at least one heat removal device 100 for cooling one or more heat-generating devices 62. As shown, the cooling system 60 may be fluidly connected to the refrigeration system 20 and configured to receive a flow of refrigerant from a location downstream from the condenser 26 and upstream from both inlets 36, 46 or from the outlet of the economizer or after the expansion valve of the economizer heat exchanger 32. In such embodiments, an expansion valve 80 may be arranged upstream from the cooling system 60 if the fluid is received from a portion of the circuit upstream of the economizer heat exchanger 32 or expansion device 28. However, in other embodiments, the inlet to the cooling system 60 may be arranged downstream, for example directly downstream, from the expansion valve 28. The term "heat-generating device" as used herein can refer to any electronic component which generates heat during operation thereof. Examples of a heat-generating device 62 include, but are not limited to a processor, power electronic devices, or another device that can provide a controlled output power by modulating and/or converting a supplied input power (e.g., a variable frequency drive, power rectifier, power converter, and the like). Such a heat-generating device 62 can be used to control the speed of a compressor and/or the speed of a fan associated with of a refrigeration system based on various predetermined system conditions. In the illustrated, non-limiting embodiment of FIG. 2, the at least one heat-generating device 62 includes a variable frequency drive operably coupled to the compressor 24 of the refrigeration system 20. In some cases, the refrigerant may be directly fed to the cooling system 100 from the condenser and expansion may happen in the heat exchanger itself or an expansion device may be an integral part of the cooling system 100.

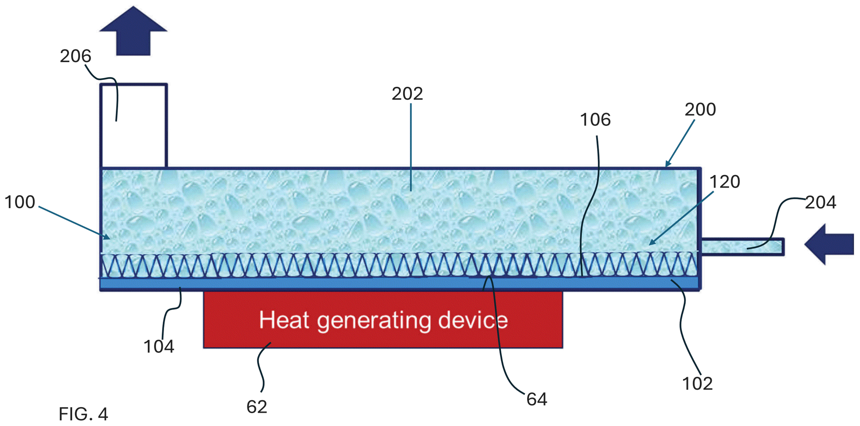

As shown, the heat removal device 100 may be a heat sink mountable in overlapping arrangement with and thermally couplable to at least one heat-generating device 62, and in some embodiments a plurality of heat-generating devices 62. Several variations of a heat removal device 100 are illustrated in FIGS. 4-14. In each of the illustrated, non-limiting embodiments, the heat removal device 100 includes a base 102 formed from any suitable material or substrate. The footprint of the base 102 may be similar or substantially identical in size and/or shape to a surface 64 of the heat-generating device 62 associated therewith. Alternatively, the footprint of the base 102 may be larger than the surface 64 of the heat-generating device 62. However, it should be understood that embodiments where the footprint of the base 102 is smaller than the surface 64 of the heat-generating device 62 through which heat is transferred to the heat removal device 100 are also within the scope of the disclosure. The base 102 may be positionable in direct contact with the surface of a heat-generating device 62 such that the base 102 is directly thermally coupled to the heat-generating device 62. However, in other embodiments, the base 102 may be thermally coupled to a heat-generating device 62 via an intermediate component (not shown), such as a heat spreader or thermal paste or thermal interface material for example.

As shown, the footprint of the base 102 may be generally rectangular in shape. However, embodiments where the base 102 having another shape are also contemplated herein. In the illustrated, non-limiting embodiments, the base 102 has a contact surface 104 positionable closest to the heat-generating device 62 and a cooling surface 106 located opposite the contact surface 104. In an embodiment, the contact surface 104 of the base 102 is arranged in contact with and is thermally coupled to the one or more heat-generating devices 62.

In the illustrated, non-limiting embodiment, the cooling surface 106 of the base 102 is oriented substantially parallel to the contact surface 104 of the base 102. As shown, the entirety of the base 102 may therefore have a uniform thickness. However, in other embodiments, different regions of the base 102 may have different thicknesses, with the cooling surface 106 of each region being parallel to the contact surface 104. It should also be understood that embodiments where the cooling surface 106 of the base 102 is arranged at a non-parallel angle relative to the contact surface 104 of the base 102 are also within the scope of the disclosure.

As shown, at least one fin 120, and in some embodiments, a plurality of fins, may be arranged at the cooling surface 106. The one or more fins 120 may be separate components affixed to the base 102, such as via brazing or another suitable bonding process for example, or alternatively, may be integrally formed with the base 102. The at least one fin 120 may be formed form any suitable material. In an embodiment, the one or more fins 120 are formed from a material having a hydrophilic surface, or alternatively, are coated with a hydrophilic coating. The at least one fin 120 may span an entire length of the cooling surface 106, or alternatively, may span only a portion thereof. Similarly, the at least one fin 120 may span an entire width of the cooling surface 106, or alternatively, may extend over only a portion of a width of the cooling surface 106. In an embodiment, the at least one fin 120 spans a length and a width of the heat-generating device 62.

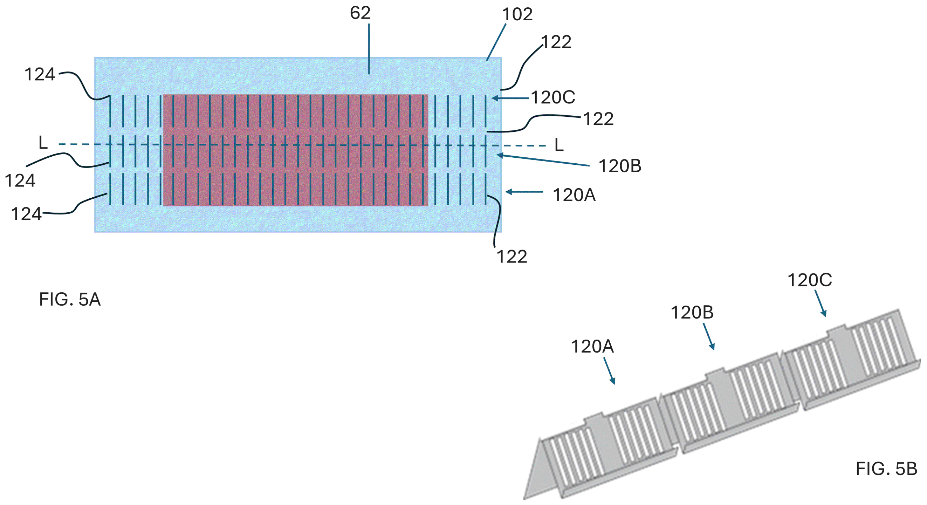

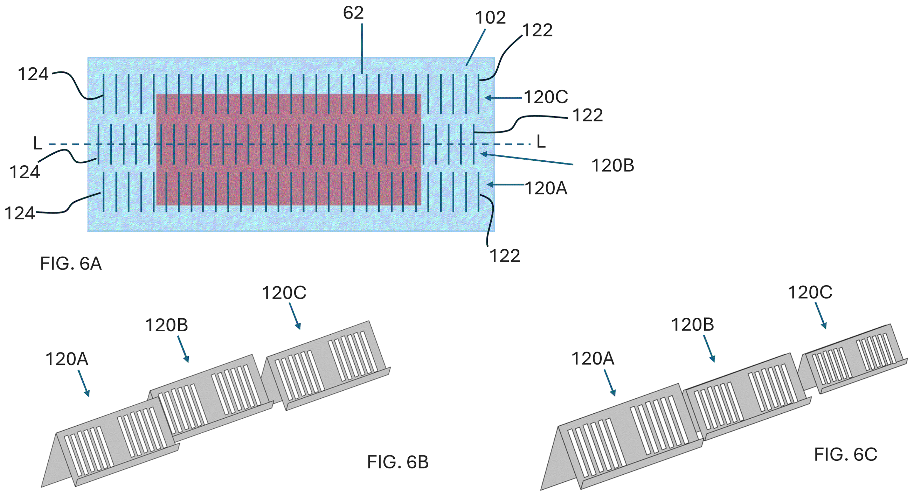

In the non-limiting embodiment illustrated in FIGS. 5A-6C, the heat removal device 100 includes a plurality of fins 120, such as a first fin 120a, a second fin 120b, and a third fin 120c for example, arranged generally inline with one another. Although the fins 120a, 120b, 120c shown in FIG. 5A, in combination, are illustrated as being sized to only span the width of the heat-generating device 62, embodiments where the plurality of fins 120a, 120b, 120c span a width greater than the width of the heat-generating device 62, such as the width of the base 102, or alternatively, a width greater than the heat-generating device 62 and less than the width of the cooling surface 106 (see FIG. 6A), are also contemplated herein. In embodiments including a plurality of fins 120, the plurality of fins 120a, 120b, 120c may have identical configurations (FIGS. 5A-5B, 6B), or may have different configurations (FIG. 6C). For example, in the non-limiting embodiment of FIG. 6C, an axial fin height, as will be described in more detail below, may vary over a width of the base 102. While the axial fin height is shown as gradually reducing between each pair of respective fins 120a, 120b, 120c, embodiments where the axial fin height varies in another manner, and embodiments where one or more other parameters of the fins 120a, 120b, 120c vary are also within the scope of the disclosure. Further, in embodiments including a plurality of fins, the plurality of fins 120a, 120b, 120c may be generally axially aligned with one another (FIG. 5B, 6C), or alternatively, adjacent fins 120a, 120b, 120c may be staggered or offset from one another (see FIGS. 6A and 6B), such as relative to a line perpendicular to the axis L of the base 102, as shown.

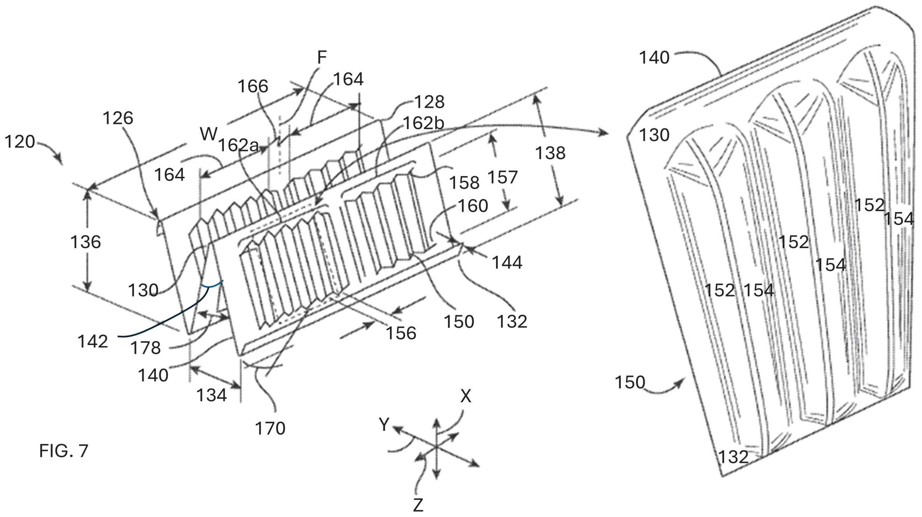

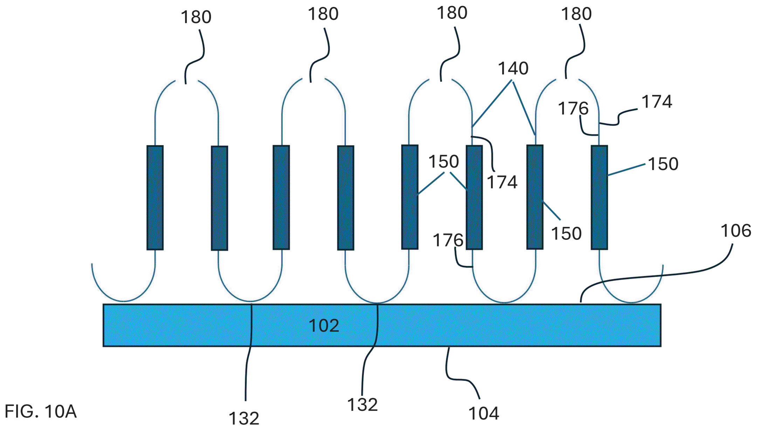

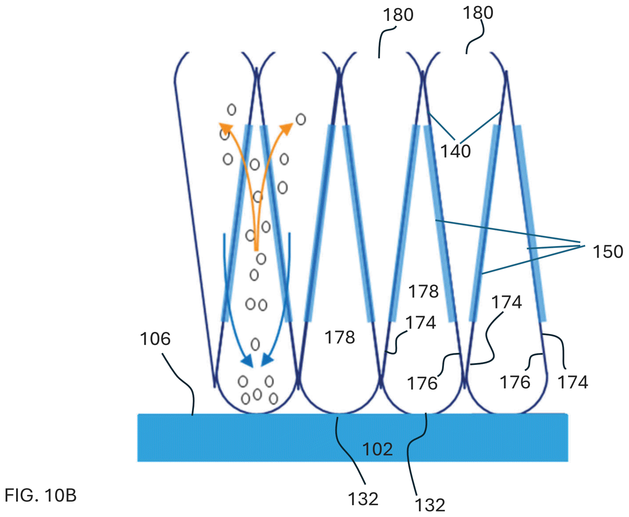

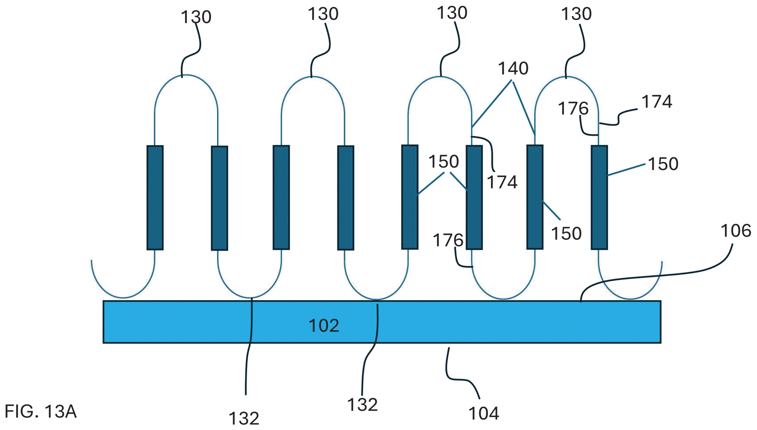

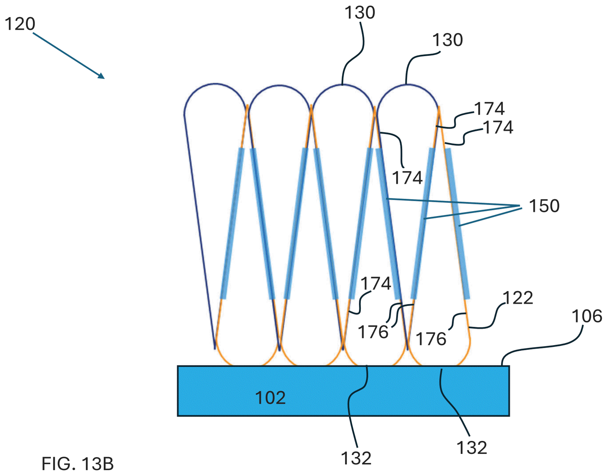

With reference to FIG. 7, a portion of a fin mountable to the cooling surface 106 of the base 102 is illustrated in more detail. As shown, the fin 120 includes a first, upstream end 122 and a second downstream end 124 spaced apart from the first, upstream end 122 in a longitudinal direction. Each fin 120 may additionally have a first lateral edge 126 and a second lateral edge 128 spaced apart from one another in a lateral direction by a fin width. As shown, a fin 120 may have a generally periodic waveform. The fin 120 therefore includes a plurality of fin tips, such as upper or apex fin tips 130 and lower fin tips 132. In an embodiment, the waveform may be generally sinusoidal, such that the fin tips 130, 132 have a generally curved configuration (see FIGS. 10A, 10B, 13A, 13B). In other embodiments where the waveform is triangular, as shown in FIGS. 4-9, 12, and 14-15B, the fin tips 130, 132 may have a pointed or angular configuration.

Pairs of apex fin tips 130 or lower fin tips 132 are spaced apart from one another in the longitudinal direction by a fin pitch 134. Further, the distance between a lower fin tip 132 and an apex fin tip 130, measured along an axial direction X extending perpendicularly to the longitudinal direction Y, may be referred to herein as the axial fin height 136. A length extending between a lower fin tip 132 and an adjacent apex fin tip 130, measured along the surface of the fin, defines a fin height 138.

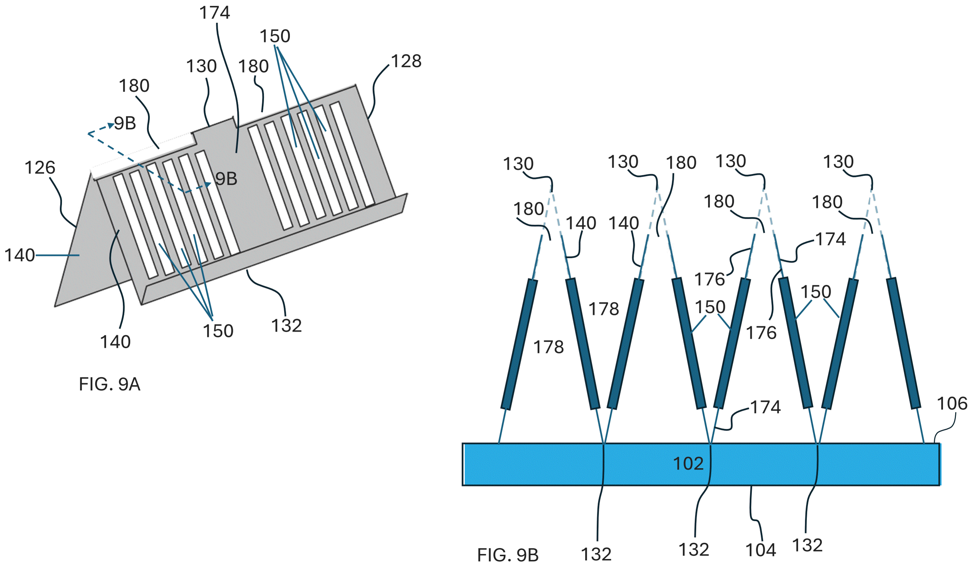

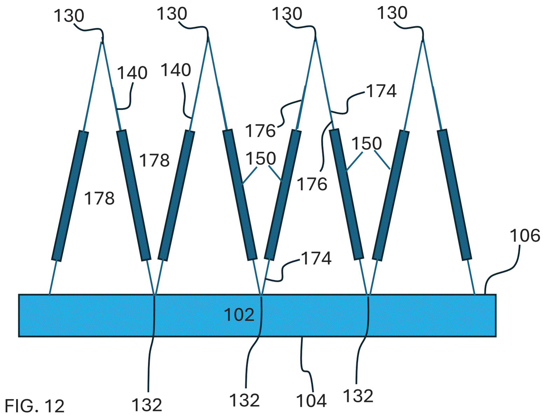

With continued reference to FIG. 7, a fin 120 may include a plurality of fin segments, referred to generally at 140, and respectively defined between an apex fin tip 130 and an adjacent lower fin tip 132. In the non-limiting embodiment of FIGS. 10A and 13A, the fin segments 140 generally extend in the axial direction X such that the plurality of fin segments 140 are substantially parallel to one another. While each of the fin segments 140 is illustrated as having a substantially uniform length in the axial direction X, in other embodiments, the length of various fin segments 140 in the axial direction X may vary. With reference to FIGS. 9, 10B, 12, and 13B, in other embodiments, adjacent fin segments 140 are arranged at a non-parallel angle relative to one another. In the non-limiting embodiments illustrated in FIGS. 10B and 13B, the fins 120 may have a generally sinusoidal waveform, but a longitudinal spacing of each channel 178 may vary over the height of the fin 120. In other embodiments, such as shown in FIGS. 9 and 12, the fin 120 may have a triangular waveform. The length of each fin segment 140 extending between a lower fin tip 132 and an adjacent apex fin tip 130, is arranged at a non-parallel angle relative to the axial direction X, and an acute angle 142 may be formed between adjacent fin segments 140, such that the fin height 138 is greater than the axial fin height 138. A channel 178 may be defined between each pair of adjacent fin segments 140.

Each fin segment 140 may include one or more louvers 150. Each louver 150 may include a louver slat 152 and a louver slot 154 arranged adjacent to one another in the lateral direction. The louver slot 154 may be a cut or slit that extends through the fin thickness 144. Accordingly, the louver slat 152 and slot 154 may be formed by cutting a first slit into the fin segment 140 and then pressing the form of the louver slat 152. This action press-forms a shape of the louver slot 154 into the fin segment 140. Each louver slat 152 may be viewed to extend along the lateral direction by a louver width 156. Each louver slat 152 and slot 154 may be viewed to extend between the lower and upper fin tips 130, 132 by a louver length 157, to respectively define upper and lower louver ends 158, 160. That is, each louver slat 152 and slot 154 pair formed from the same slit may have the same louver length 158. However, different pairs of louver slats 152 and slots 154 may have different lengths relative to each other.

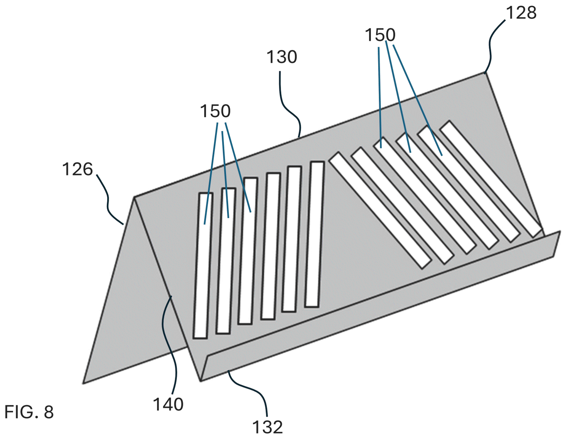

In the non-limiting embodiment illustrated in FIG. 7, the plurality of louvers 150 are oriented generally parallel to an adjacent lateral edge of the fin 120, such as the first lateral edge 126 or the second lateral edge 128 for example. However, in other embodiments, the louvers 150 may be arranged at a non-parallel angle relative to a lateral edge 126, 128 of the fin. As shown in FIG. 8, the portion of a louver 150 proximate the upper fin tip 130 is spaced from a nearby lateral edge 126, 128 a greater distance than the portion of the louver 150 proximate the lower fin tip 132. Accordingly, the louvers 150 may be considered to have a slanted configuration, or to slant inwardly from an adjacent lateral edge 126, 128.

The louvers 150 formed in each fin segment 140 may define a single louver bank, or alternatively, may define a plurality of louver banks distributed between the first and second lateral edges 126, 128. In the illustrated, non-limiting embodiments, each fin segment 140 includes a first louver bank 162a and a second louver bank 162b. However, embodiments including more than two louver banks 162a, 162b are also contemplated herein. As shown, the first louver bank 162a is arranged between the first lateral edge 126 of the fin segment 140 and a fin length bisecting axis F that extends along the fin height 138 to bisect the fin segment 140, and the second louver bank 162b is distributed between the fin length bisecting axis F and the second lateral edge 128 of the fin segment 140. The first and second louver banks 162a, 162b may each extend along a same span 164, with an interrupted louver gap 166 therebetween, centered on the fin length bisecting axis F.

The first louver bank 162a may have a first-side louver angle 170 defined by the upper and lower louver ends 158, 160 that may be acute relative to the axial direction X such that the louver slot 154 forms an outwardly splayed aperture or air scoop. The second louver bank 162b may be configured to essentially mirror the first louver bank 162a. Each fin segment 140 may include opposing fin segment surfaces, forming an upstream segment surface 174 and a downstream segment surface 176 of the fin segment 140. The louvers 150 may be press-formed to extend across both the upstream and downstream segment surfaces 174, 176 and extend a distance from both lower and upper fin tips 132, 130. The louver slot 154 may form an air scoop, otherwise referred to as a louver entry or exit, on one of the segment surfaces 174, 176, to direct flow over the other one of the segment surfaces 174, 176. The upstream and downstream segment surfaces 174, 176 of adjacent fin segments 140 may form an adjoining pair of inner facing side surfaces that face each other along the longitudinal direction Y and a pair of adjoining outer facing side surfaces that face away from each other along the longitudinal direction. Although a fin 120 having louvers 150 is illustrated and described herein, it should be understood that the fin 120 may alternatively or additionally include dimples of corrugations.

With reference again to FIG. 5, and further reference to FIGS. 9A-10B, the configuration of the heat removal device 100 may be selected to promote thin film evaporation and/or nucleate boiling proximate the cooling surface 106. In the illustrated, non-limiting embodiments, one or more openings 180, also referred to herein as apex openings, may be formed at an apex fin tip 130 of a fin 120 of the heat removal device. The fin 120 illustrated in FIGS. 9A and 9B has a triangular waveform including at least one apex tip opening 180. As shown, the apex tip opening 180 extends over only a portion of the apex tip 130. In an embodiment, the interface between adjacent fin segments 140 may include a plurality of apex tip openings 180, each being associated with a corresponding louver bank of the plurality of louver banks 162a, 162b. The opening(s) 180 may have a width equal to a respective louver bank 162a, 162, or alternatively, may have a width shorter or greater than a respective louver bank 162a, 162b. Inclusion of the louvers 150 in the fin segments 140 and the one or more openings 180 at the apex tips 130 of a fin facilitates the mixing of flow between adjacent channels 178, and a flow through the openings 180. It should be appreciated that in embodiments including a plurality of fins, such as shown in FIGS. 5A-6B, the fluid is configured to flow not only between the upstream end 122 and the downstream end 124 of the fins 120A-120C, but also from the first fin 120A toward the last fin, such as fin 120C. In some embodiments, the bulk of the fluid flow through the housing 102 occurs between the adjacent fins rather than between the inlet and outlet ends 122, 124 of each fin 120A-120C.

Fluid at the interface with the cooling surface vaporizes. As the resulting vapor bubbles separate from the cooling surface 106, fresh liquid contacts the cooling surface where the vapor bubbles were previously located. This liquid is then vaporized to form more bubbles. The vaporization of the liquid and the continual replacement of the liquid adjacent to the cooling surface 106, as well as the agitation of the liquid caused by the movement of the vapor bubbles results in improved heat transfer at the cooling surface 106.

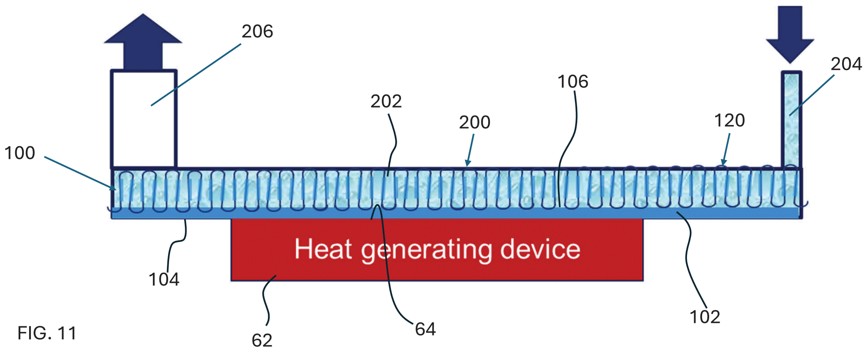

In the illustrated, non-limiting embodiments of FIGS. 11-13B, the configuration of the heat removal device 100 may be selected to promote flow boiling proximate the cooling surface 106. The fins shown in FIGS. 12-13B may be substantially similar to the fins 120 described above with respect to FIGS. 9-10B. In operation, fluid at the cooling surface 106 vaporizes, and as the resulting vapor bubbles separate from the cooling surface 106, fresh liquid contacts the cooling surface 106 where the vapor bubbles were previously located. However, unlike the fins 120 of the previous embodiments that facilitate nucleate boiling, no openings 180 are formed at the apex tips 130 of the fins 120 of FIGS. 12-13B. Accordingly, the vapor bubbles formed as the fluid contacts that cooling surface 106 are not able to escape from the fins 120 via the openings 180 as previously described. Rather, the fluid including the vapor bubbles will flow along the channels 178 formed by fins (in a direction into the paper) and also interact between adjacent channels 178 via a passageway defined by the louvers 150 fluidly connecting adjacent fin segments 14. Accordingly, fluid provided to the inlet of the cooling device 100 and therefore the upstream end 122 of a fin 120 may flow through the passageway, such as parallel to the longitudinal axis of the fin 120, until reaching the downstream end 124 of the fin 120.

Inclusion of the louvers 150 in the fin segments 140 of a fin facilitates a flow between the plurality of channels 178, enhances the flow mixing within the heat removal device 100. Further, in embodiments where the louvers 150 extend at a non-parallel louver angle 170 relative to an adjacent segment surface 174, 176, the louvers 150 may prevent the formation of slug bubbles and may increase wetting of the segment surfaces 174, 176. In embodiments including a plurality of fins 120, staggering adjacent fins 120, such as along a width of the base plate 102 for example, this offset configuration may further enhance flow mixing and liquid distribution within the heat removal device 100. In some embodiments, varying the axial fin height 138 spanning a length of the heat removal device 100, such as reducing the length of the axial fin height 138 for example, may be used to increase the amount of vapor present near an outlet of the heat removal device 100. In such embodiments, the variation in axial fin height 138 may be achieved either via a plurality of adjacent fins 120 or by changing the axial fin height of the fin segments 140 within a single fin 120.

Although the heat removal device 100 of FIG. 5 is illustrated and described as having at least one fin 120 configured to facilitate nucleate boiling and the heat removal device 100 of FIG. 11 is illustrated and described as having at least one fin 120 configured to facilitate pool boiling, embodiments where a heat removal device 100 includes both fins 120 configured to facilitate nucleate boiling and fins 120 configured to facilitate pool boiling are within the scope of the disclosure.

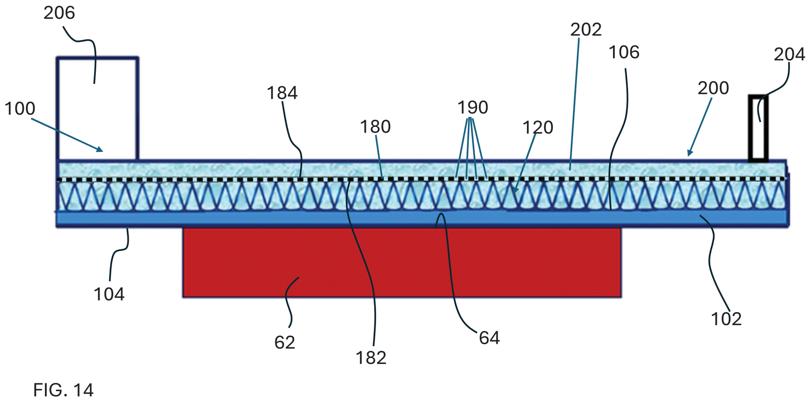

With reference now to FIGS. 14-15B, in some embodiments, a heat removal device 100 includes at least one top cover or baffle 190 with multiple openings positioned upwardly adjacent to a distal end of one or more of the fins 120. Although fins 120 configured for flow boiling (no apex tip opening 180) are illustrated in the FIGS. it should be understood that in some embodiments, a baffle 180 may be associated with fins configured for nucleate boiling (including apex tip openings 180). The at least one baffle 190 may be formed from any suitable material. Examples of such materials include metal, such as aluminum or steel, composite, or plastic. Such a baffle 190 may be permanently affixed to at least a portion of the one or more fins 120, or alternatively, may be movably arranged thereon. In embodiments where a baffle 190 is permanently affixed to one or more of the plurality of fins 120, it should be appreciated that the baffle 190 may be integrally formed with one or more of the plurality of fins 120.

In embodiments including a single baffle 190, the baffle 190 may be substantially identical in size and shape to the cooling surface 106 of the base 102, or alternatively, to the portion of the cooling surface 106 in overlapping arrangement with the heat-generating device 62. However, embodiments where the baffle 190 is a different shape than the cooling surface 106 of the base 102 and/or embodiments where the baffle 190 differs in size from the cooling surface 106 of the base 102 are also contemplated herein. In embodiments including multiple baffles 190, the plurality of baffles 190, in combination, may but need not be substantially identical in size and shape to the cooling surface 106 of the base 102, or the portion of the cooling surface 106 in overlapping arrangement with the heat-generating device 62. In an embodiment, the one or more baffles 190 of the heat removal device 100 may have a size and shape suitable to overlap the entirety of the one or more fins 120.

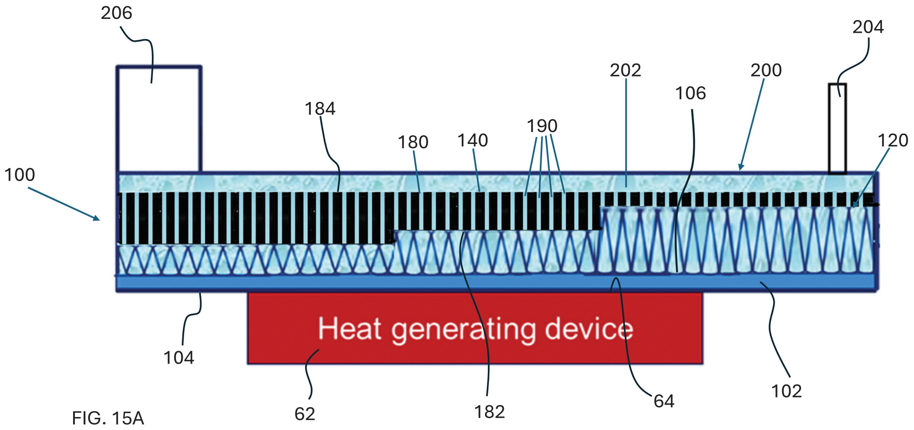

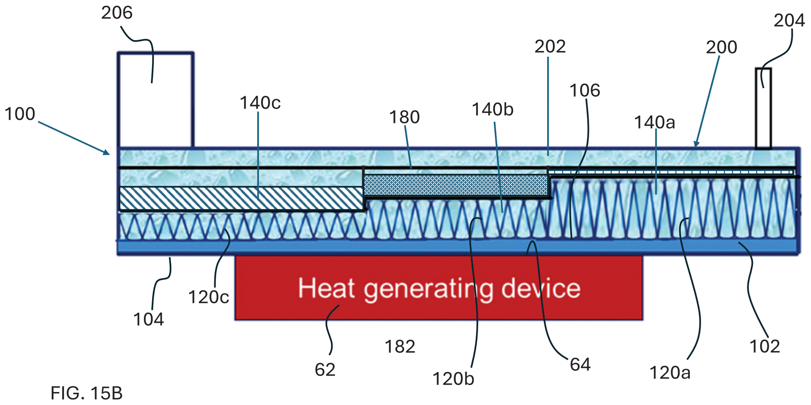

In embodiments where the axial fin height varies 138 in one or more directions relative to the cooling surface 106, the configuration of the one or more baffles 190 may similarly vary. In the non-limiting embodiment of FIG. 15A ,a single baffle includes a plurality of regions, each region being associated with a fin 120 or with fin segments 140 of a fin 120 having a specific axial fin height. In such embodiments, a thickness of the baffle 190 may vary in one or more directions in a manner corresponding to the fins 120 or fin segments 140. In other embodiments, a different baffle 190 may be associated with each fin 120 of a given axial fin height 138, or with a region of fin segments 140 having a specific fin axial height 138. In the illustrated, non-limiting embodiment, three different fins 120a, 120b, 120c are shown, each having a plurality of fin segments 140a, 104b, 140c having a uniform axial fin height 138, and a corresponding baffle 190a, 190b, 190c is associated with each group of fin segments 140a, 140b, 140c. As shown, a corresponding baffle 190a, 190b, 190c is in overlapping arrangement with each respective group of fin segments 140a, 140b, 140c. In such embodiments, an upper surface of the plurality of baffles 190a, 190b, 190c may but need not be coplanar.

Further, as shown in FIGS. 14-15A, the one or more baffles 190 may have a plurality of through holes or perforations 192 formed therein. In an embodiment, a baffle 190 includes a plurality of substantially identical perforations 192. However, in other embodiments, a configuration of the plurality of perforations 192 may vary over the baffle 190. The plurality of perforations 192 may but need not be generally uniformly spaced over the baffle 190. The perforations 192 may provide a passageway through which a vaporized cooling fluid R can vent from the heat removal device 100.

The baffle 190 in combination with the base 102 having one or more fins 120 may create a cavity structure. The louvers 150 formed in adjacent fin segments 140 may define a flow boiling flow path that extends generally between a first end and an opposite end of the base 102. However, the baffle 190 may be operable to control at least a portion of the boiling of the cooling fluid R that occurs at the heat removal device 100. A portion of the vapor cooling fluid R arranged within the flow path may be able to vent or escape through the plurality of perforations 192 formed in the baffle 190 over the length of the flow path. In an embodiment, the vapor that escapes from the heat removal device 100 via the perforations 192 in the baffle 190 develops a thin film of liquid cooling fluid on the surface on the fins and cooling surface 106. Any excess liquid may fall from the surface of the baffle 190 back to the base 102 or the fins 120 via a perforation 192 in the baffle 190.

The purpose of the heat removal device 100 disclosed herein is to facilitate thin film boiling. As the base 102 of the heat removal device 100 is in contact with heat generating device 62, heat will transfer to the cooling fluid present at the cooling surface 106. This heat causes the cooling fluid at the heat removal device 100 to boil due to bubble nucleation. Adjacent bubbles may merge to form a larger bubble. Inclusion of the louvers 150 may prevent bubbles from becoming too large and as a result, maintain a surface wetness of the cooling surface 106 and the one or more fins 120. As a bubble travels, it will sweep over other nucleating bubbles arranged along its flow path to create a thin film of liquid along the surfaces defining the at least one flow path, such as the segment surfaces 174, 176 of the fin segments 140 for example and also on the surface 106. This thin film evaporates due to heat coming from heat generating device 62 and is an ultra-efficient heat transfer mechanism. The high heat transfer and evaporation rates result in generation of a large volume of vapor. Perforations 192 may be formed in the at least one baffle 190 at specific locations to facilitate vapor venting.

The heat removal device 100, and in some embodiments the one or more adjacent heat-generating devices 62, may be part of a closed loop system. In an embodiment, the cooling surface 106 is completely enclosed within the interior 202 of a housing 200 of the heat removal device 100. As shown in FIGS. 5, 11, and 14-15B, the housing 200 includes and inlet 204 and an outlet 206 defining a flow path of the cooling fluid through the interior 202 of the heat removal device 100. In such embodiments, the at least one heat-generating device 62 may not be arranged within the interior 202 of the housing 200. As shown, in embodiments including a baffle 190 in overlapping arrangement with a top of the one or more fins 120, the baffle 190 may, but need not be offset from a surface of the housing 200 by a clearance such that a vapor region within which vapor is receivable is defined between the baffle 190 and the housing 200. Inclusion of a housing 200 may facilitate the use of the heat removal device 100 in a plurality of configurations, such as a horizontal configuration, as shown in FIGS. 4 and 6, and a vertical configuration. However, it should be appreciated that embodiments where the heat removal device 100 is arranged at another configuration are also within the scope of the disclosure.

Within the housing 200 at least a portion of the heat removal device 100, and in some embodiments, the entirety of the heat removal device 100, is submerged in a cooling fluid during normal operation. Accordingly, the mass and/or flow rate of the cooling fluid that vaporizes via interaction with the heat removal device 100 and is provided to the outlet 206 associated therewith may be equal to the mass and/or flow rate of the liquid or two-phase cooling fluid provided to the heat removal device 100 via the inlet 204.

A heat removal device 100 as disclosed herein can achieve a high heat removal rate, thereby maintaining a corresponding heat-generating electronic device at or below a temperature threshold. It should be appreciated that although the heat removal device 100 is illustrated and described herein with respect to electronics of an HVAC system, such a heat removal device may be suitable to cool any heat-generating component.

The term "about" is intended to include the degree of error associated with measurement of the particular quantity based upon the equipment available at the time of filing the application.

The terminology used herein is for the purpose of describing particular embodiments only and is not intended to be limiting of the present disclosure. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, element components, and/or groups thereof.

While the present invention has been described with reference to an exemplary embodiment or embodiments, it will be understood by those skilled in the art that various changes may be made and equivalents may be substituted for elements thereof without departing from the scope of the present invention as defined by the appended claims. In addition, many modifications may be made to adapt a particular situation or material to the teachings of the present invention without departing from the scope of the invention as defined by the appended claims. Therefore, it is intended that the present invention not be limited to the particular embodiment disclosed as the best mode contemplated for carrying out this present invention, but that the present invention will include all embodiments falling within the scope of the claims.

## Claims

1. A heat removal device (100) operable to cool a heat-generating device (62), the heat removal device comprising:
a housing (200) having a hollow interior (202);
a base (102) arranged within the hollow interior of the housing, the base including a contact surface (104) and a cooling surface (106), the contact surface being thermally couplable to the heat-generating device; and
at least one fin (120) including a plurality of fin segments (140), the at least one fin being arranged at the cooling surface, wherein at least one of the plurality of fin segments includes a plurality of louvers (150).

2. The heat removal device of claim 1, wherein the plurality of fin segments have a uniform axial fin height, and/or wherein the at least one fin includes a plurality of fins, each of the plurality of fins having a plurality of fin segments, wherein the plurality of fin segments of each fin of the plurality of fins have a uniform axial fin height.

3. The heat removal device of claim 1, wherein an axial fin height of the plurality of fin segments varies between an inlet (204) of the housing toward an outlet (206) of the housing.

4. The heat removal device of claim 3, wherein the at least one fin includes a single fin, and the axial fin height of the plurality of fin segments of the single fin vary.

5. The heat removal device of claim 3, wherein the at least one fin includes a plurality of fins, each of the plurality of fins having a plurality of fin segments, wherein the plurality of fin segments of each fin of the plurality of fins have a uniform axial fin height, optionally wherein the plurality of fins includes a first fin and a second fin, and the axial fin height of the plurality of fin segments of the first fin is different than the axial fin height of the plurality of fin segments of the second fin.

6. The heat removal device of any of claims 3 to 5, wherein the axial fin height of the plurality of fin segments varies in a first direction and a second direction, the second direction being arranged at a non-parallel angle relative to the first direction.

7. The heat removal device of any of claims 1 to 6, wherein the at least one fin includes a plurality of fins mounted in a lateral direction of the base, the plurality of fins being staggered relative to one another with respect to a longitudinal axis of the base.

8. The heat removal device of any of claims 1 to 7, wherein the at least one fin has one of a triangular waveform and a sinusoidal waveform, and/or wherein the at least one fin includes one of a hydrophilic material and a hydrophilic surface coating.

9. The heat removal device of any of claims 1 to 8, wherein the plurality of fin segments include louvers, optionally wherein a plurality of channels (178) are formed between adjacent fin segments of the plurality of fin segments, the plurality of channels being fluidly connected by the louvers.

10. The heat removal device of any of claims 1 to 9, further comprising a plurality of apex fin tips (130) defined at an interface between respective pairs of adjacent fin segments of the plurality of fin segments, wherein at least one opening is formed at the plurality of apex fin tips.

11. The heat removal device of any of claims 1 to 10, further comprising at least one baffle (190) positioned upwardly adjacent to the plurality of fin segments, the at least one baffle having a plurality of perforations (192) formed therein.

12. The heat removal device of claim 11, wherein the at least one baffle includes a plurality of baffles, wherein each of the plurality of baffles has a surface positioned closest to the fin, the surface of each of the plurality of baffles being arranged within a different plane, optionally wherein the plurality of fin segments are arranged in groups of fin segments having different axial fin heights, each baffle of the plurality of baffles being associated with one of the groups of fin segments.

13. The heat removal device of any of claims 11 or 12, wherein the at least one baffle is separated from an adjacent surface of the housing by a clearance to define a vapor region within the hollow interior of the housing.

14. A heat removal device (100) operable to cool a heat-generating device (62), the heat removal device comprising:
a housing (200) having a hollow interior (202);
a base (102) arranged within the hollow interior of the housing, the base including a contact surface (104) and a cooling surface (106), the contact surface being thermally couplable to the heat-generating device; and
at least one fin (120) arranged at the cooling surface, the at least one fin including a plurality of fin segments (140); and
a plurality of apex fin tips (130) defined at an interface between respective pairs of adjacent fin segments of the plurality of fin segments, wherein at least one opening (180) is formed at the plurality of apex fin tips.

15. The heat removal device of claim 14, further comprising a plurality of channels (178) defined between adjacent fin segments, optionally: wherein one or more of the plurality of channels is fluidly connected to an outlet (206) of the housing via the at least one opening formed at the plurality of apex fin tips; and/or wherein at least one of the plurality of fin segments includes a plurality of louvers (150), and the plurality of channels are fluidly connected via the plurality of louvers.
